# EUROPEAN PATENT SPECIFICATION

(11) **EP 2 669 107 B1**
(45) Date of publication and mention of the grant of the patent: **19.08.2015**
(21) Application number: 11857330.2
(22) Date of filing: 27.01.2011
(51) Int. Cl.: B60K 11/06, B60K 1/04, B60K 6/22, B60L 3/00, B60L 11/18, B60K 6/52, B60L 11/14, H01M 10/613, H01M 10/625, B62D 43/00, B60K 1/00, B60K 6/448, B60L 1/00, B60L 1/02, B60L 11/02, B60L 11/12, F01P 1/00, H05K 7/20, H01M 10/6563

(54) **COOLING APPARATUS**
KÜHLVORRICHTUNG
APPAREIL DE REFROIDISSEMENT

(43) Date of publication of application: 04.12.2013
(73) Proprietor: TOYOTA JIDOSHA KABUSHIKI KAISHA, Toyota-shi, Aichi-ken, 471-8571 (JP)
(72) Inventor: MIYAMOTO, Shingo, Toyota-shi, Aichi-ken, 471-8571 (JP)
(74) Representative: Intès, Didier Gérard André
(86) International application number: PCT/JP2011/051556
(87) International publication number: WO 2012/101795

(56) References cited:
- EP-A1- 1 932 707
- EP-A1- 1 935 699
- EP-A1- 2 241 468
- WO-A1-2004/025809
- DE-U1- 9 410 158
- JP-A- 2000 247 261
- JP-A- 2004 203 073
- JP-A- 2004 336 845
- JP-A- 2005 205 953
- JP-A- 2008 062 780
- JP-A- 2008 062 781

## Description

### TECHNICAL FIELD

The present invention relates to a cooling apparatus, and more particularly, to a cooling apparatus for cooling heat-generating devices mounted on a vehicle.

### BACKGROUND ART

With regard to conventional cooling apparatuses, Japanese Patent Laying-Open No. 2003-283171 discloses a cooling structure for an electronic circuit board wherein a negative pressure is generated, using cooling wind that has cooled a principal heat-generating element on the electronic circuit board, to cool another peripheral heat-generating element. Japanese Patent Laying-Open No. 2000-174474 discloses a cooling apparatus for an electronic device having a plurality of heat-generating members arranged thereon and having a casing, including a guide member, provided between the plurality of heat-generating members, for guiding an airflow, wherein a desired heat-generating member of the plurality of heat-generating members is forced-air cooled, and the air is simultaneously supplied along the guide member, and another heat-generating member different from the desired heat-generating member is cooled by natural air-cooling, using a negative pressure produced at an end of the guiding member by the air supplied along the guide member.

Japanese Patent Laying-Open No. 2005-301905 discloses a radiator that is configured to create a second flow of air, utilizing a pressure difference produced by a first flow of air that is created by air-cooling means for air-cooling a heat-generating portion, thereby radiating heat from a second heat-generating portion. Japanese Patent Laying-Open No. 2008-62780 discloses a cooling structure including, below a floor behind a seat of a vehicle, a battery module disposed in a lower section, and a DC/DC converter and an inverter disposed in an upper section, wherein cooling air divides into upper and lower flows to cool the battery module, and the DC/DC converter and the inverter, respectively, in parallel.

A cooling apparatus comprising the features of the pre-amble of claim 1 is known from EP 1 932 707 A1.

### SUMMARY OF INVENTION

### TECHNICAL PROBLEM

The cooling structure disclosed in Japanese Patent Laying-Open No. 2003-283171 had a problem in that the cooling wind for cooling the principal heat-generating element passes through complicated fins and is subjected to a pressure loss, and therefore, it does not create an airflow sufficient to generate a negative pressure for cooling other heat-generating elements.

The present invention has been made in view of the above-described problem. A principal object of the invention is to provide a cooling apparatus capable of efficiently cooling a plurality of heat-generating devices.

### SOLUTION TO PROBLEM

A cooling apparatus according to the present invention is a cooling apparatus for cooling a plurality of heat-generating devices mounted on a vehicle, the vehicle having a hollow space that can accommodate a spare tire. The cooling apparatus includes: a cooling-air passage disposed adjacent to the hollow space; a first heat-generating device disposed in the cooling-air passage; a second heat-generating device disposed in the hollow space; and a fan for supplying air to the cooling-air passage. A communicating portion providing communication between the cooling-air passage and the hollow space is formed in a wall portion of the cooling-air passage facing the hollow space.

In the cooling apparatus, the second heat-generating device is preferably disposed in proximity to a wall portion of the hollow space. The second heat-generating device may be disposed to face the communicating portion.

In the cooling apparatus, the fan may be disposed upstream of the first heat-generating device in the cooling-air passage, or may be disposed downstream of the communicating portion in the cooling-air passage.

In the cooling apparatus, the second heat-generating device preferably has radiator fins. The radiator fins may be pin fins, or plate fins aligned perpendicularly to the wall portion.

In the cooling apparatus, each of the heat-generating devices may be any of a battery, an inverter, and a DC-DC converter.

### ADVANTAGEOUS EFFECTS OF INVENTION

According to the cooling apparatus of the present invention, the plurality of heat-generating devices can be efficiently cooled by air-cooling.

### BRIEF DESCRIPTION OF DRAWINGS

Fig. 1 is a schematic diagram showing the configuration of a vehicle according to a first embodiment.
Fig. 2 is a schematic diagram showing the configuration of a cooling apparatus of the first embodiment when viewed planarly.
Fig. 3 is a schematic diagram showing the configuration of the cooling apparatus of the first embodiment when viewed laterally.
Fig. 4 is a schematic perspective view showing an example of radiator fins provided on an inverter.
Fig. 5 is a schematic perspective view showing another example of radiator fins provided on the inverter.
Fig. 6 is a schematic diagram showing the configuration of a cooling apparatus of a second embodiment when viewed laterally.

### DESCRIPTION OF EMBODIMENTS

Embodiments of the invention will be described below with reference to the drawings, in which the same or corresponding parts have the same reference characters allotted, and the description thereof will not be repeated.

### (First Embodiment)

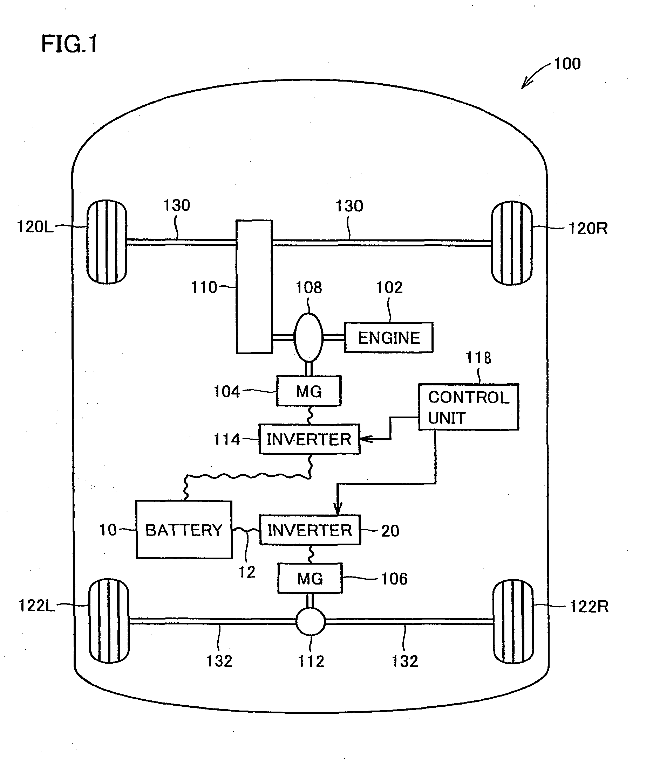

Fig. 1 is a schematic diagram showing the configuration of a vehicle 100 according to a first embodiment. Vehicle 100 is a hybrid car that uses an engine and motors as driving power sources for propelling the vehicle. Referring to Fig. 1, vehicle 100 includes front wheels 120R, 120L, rear wheels 122R, 122L, a front-wheel driveshaft 130 for transmitting driving force to front wheels 120R, 120L, and a rear-wheel driveshaft 132 for transmitting driving force to rear wheels 122R, 122L.

Vehicle 100 includes an engine 102, a power split device 108, a motor generator 104, and a reduction and differential mechanism 110. Reduction and differential mechanism 110 may include, for example, a transmission such as a continuously variable transmission. Vehicle 100 further includes a motor generator 106 for driving the rear wheels, and a differential gear 112 for transmitting the rotation of motor generator 106 to the left and right rear-wheel driveshafts. Differential gear 112 may include a reduction gear. Motor generator 104 will also be referred to as a front motor, and motor generator 106 as a rear motor.

Vehicle 100 further includes a battery 10, a forward inverter 114, a rear inverter 20, and a control unit 118. Control unit 118 may include a plurality of ECUs (Electronic Control Units) that are arranged in a distributed manner.

Battery 10, which is a DC electric power supply, includes secondary batteries, for example, nickel metal hydride or lithium-ion batteries, and supplies DC electric power to inverters 114, 20, and is also charged by receiving electric power from inverters 114, 20. Alternatively, a booster may be provided between each inverter and the battery to raise an output voltage from battery 10 to supply the voltage to each of inverters 114, 20, and lower a voltage from each of inverters 114, 20 to supply the voltage to battery 10.

Battery 10 and each of inverters 114 and 20 are electrically connected to each other via a cable 12. Inverter 114 and motor generator 104 are also electrically connected via cable 12, and inverter 20 and motor generator 106 are also electrically connected via cable 12. Motor generators 104, 106 supply or regenerate electric power to battery 10 via inverters 114, 20, respectively. DC electric power from battery 10 is converted to an alternating current by inverters 114, 20, and then supplied to motor generators 104, 106.

Each of inverters 114, 20 is controlled by control unit 118. Control unit 118 drives motor generator 104 via inverter 114 in response to, for example, a request for acceleration. Control unit 118 also sends an instruction to inverter 20 when a running state of the vehicle that is obtained from outputs from various sensors has fulfilled predetermined conditions, causing motor generator 106 to generate a torque to drive rear wheels 122R, 122L.

Examples of running conditions of the vehicle for driving rear wheels 122R, 122L include full-throttle acceleration, and slipping on a slippery road surface such as a snowy road. Rear wheels 122R, 122L are intermittently driven. Electric power is intermittently supplied from battery 10 to inverter 20 on the rear-wheel side. Therefore, the capacity of inverter 20 is smaller than that of inverter 114 on the front-wheel side; hence, the amount of heat generated by inverter 20 is smaller than that generated by inverter 114.

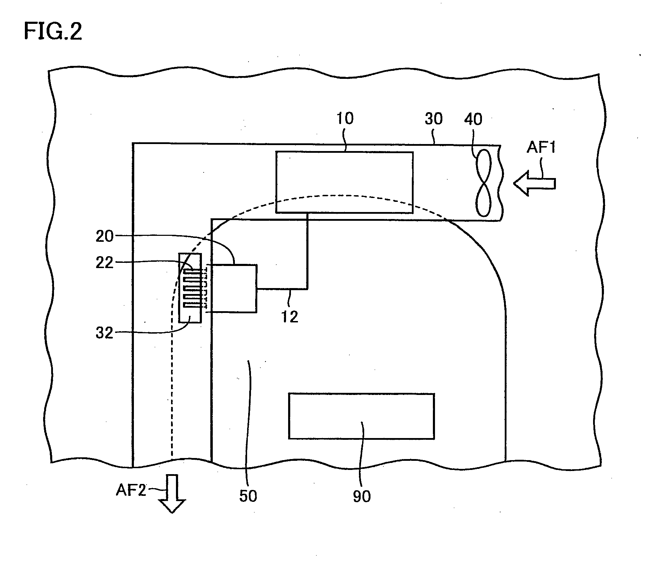

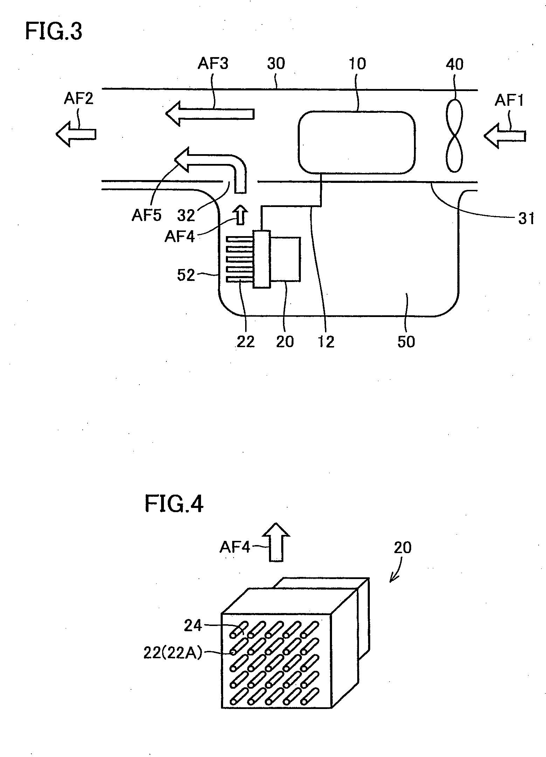

Fig. 2 is a schematic diagram showing the configuration of a cooling apparatus of the first embodiment when viewed planarly. Fig. 3 is a schematic diagram showing the configuration of the cooling apparatus of the first embodiment when viewed laterally. The cooling apparatus of the present embodiment is a cooling apparatus for on-board devices, for cooling battery 10 and inverter 20 representing a plurality of heat-generating devices mounted on vehicle 100. Referring to Figs. 2 and 3 as required, the configuration of the cooling apparatus of the present embodiment will be described.

In vehicle 100, a hollow space 50 is formed on a rear side of vehicle 100 along a traveling direction. Hollow space 50 is formed to have such a shape that a spare tire can be accommodated therein. Hollow space 50 has a profile that is recessed downward so that a spare tire can be inserted from above. Hollow space 50 is a space that is shaped and dimensioned to contain a spare tire inside; however, in practice, a spare tire is not accommodated therein. Accommodated inside hollow space 50 is a puncture repair kit 90 that is mounted on vehicle 100 instead of a spare tire. Additionally, inverter 20 is accommodated inside hollow space 50.

In order to conform to the legal regulations of some countries under which the mounting of a spare tire is obligatory, hollow space 50 that can accommodate a spare tire is formed in vehicle 100. In other countries, on the other hand, even if a spare tire is not mounted, there is no problem in terms of legal regulations as long as puncture repair kit 90 is mounted on vehicle 100 as a substitute for a spare tire. When a spare tire is not mounted on vehicle 100, a spare tire is not housed in hollow space 50. Here, if hollow space 50 is left empty, the inside of hollow space 50 will be a dead space. Thus, inverter 20 is disposed inside hollow space 50, thereby effectively utilizing hollow space 50 in which a spare tire is not housed.

Inverter 20 is disposed inside hollow space 50, in proximity to a wall portion 52 that forms a sidewall of hollow space 50. Inverter 20 has radiator fins 22 for increasing the radiation area when releasing the generated heat to the outside, and radiator fins 22 are disposed to face wall portion 52.

A cooling-air passage 30 is disposed adjacent to hollow space 50. Cooling-air passage 30 is disposed above hollow space 50 to extend along a portion of the profile of hollow space 50. Battery 10 is disposed inside cooling-air passage 30. Because inverter 20 is disposed in hollow space 50 and battery 10 is disposed in cooling-air passage 30 adjacent to hollow space 50, the length of cable 12 that connects battery 10 to inverter 20 can be reduced, resulting in a reduced manufacturing cost of cable 12, as compared to cases where inverter 20 is disposed on a forward side of vehicle 100.

A fan 40 is also disposed in cooling-air passage 30. Fan 40 supplies air to cooling-air passage 30. Fan 40 is disposed upstream of battery 10 in cooling-air passage 30. When fan 40 is driven, air flows into cooling-air passage 30, as indicated by an airflow AF1 shown in Fig. 2, and the air flows out of cooling-air passage 30, as indicated by an airflow AF2. Fan 40 ventilates air inside cooling-air passage 30.

The cooling apparatus of the present embodiment is intended to efficiently cool both of battery 10 as a first heat-generating device disposed in cooling-air passage 30 and inverter 20 as a second heat-generating device disposed in hollow space 50, by using fan 40 alone.

A communicating portion 32 that provides communication between cooling-air passage 30 and hollow space 50 is formed in a wall portion 31 that faces hollow space 50. Inside hollow space 50, inverter 20 is disposed to face communicating portion 32. Inverter 20 is disposed so that radiator fins 22 formed on inverter 20 face communicating portion 32. Communicating portion 32 is formed to have a rectangular slit shape that corresponds to the shapes of radiator fins 22 aligned in a rectangular form in the plan view shown in Fig. 2.

When fan 40 is activated, air is ventilated in cooling-air passage 30, as indicated by an airflow AF3 shown in Fig. 3. This circulating air removes heat generated by battery 10, and achieves forced air-cooling of battery 10. Moreover, because a flow of air is created in cooling-air passage 30, the atmospheric pressure in cooling-air passage 30 drops to a negative pressure in accordance with Bernoulli's theorem. This causes a pressure difference between the inside of cooling-air passage 30 and the inside of hollow space 50. That is, the internal pressure of hollow space 50 is relatively higher than that of cooling-air passage 30.

Due to this pressure difference, a flow of air from hollow space 50 toward cooling-air passage 30 is created, as indicated by an airflow AF4 shown in Fig. 3. Airflow AF4 flows along radiator fins 22 of inverter 20, and removes heat from radiator fins 22, to cool inverter 20. Therefore, in the present embodiment, an airflow is created in cooling-air passage 30 by fan 40, thereby allowing the two heat-generating devices, i.e., battery 10 and inverter 20, to be cooled simultaneously. Without any special mechanism being provided in hollow space 50, inverter 20 disposed in hollow space 50 can be cooled by natural air-cooling, thus achieving reduction in the cost and size of a cooling apparatus.

As indicated by an airflow AF5, the air heated by the heat generated by inverter 20 passes via communicating portion 32 into cooling-air passage 30, and then sucked into the cooling-air passage 30 side. Communicating portion 32 serves as an air-intake port from hollow space 50 to cooling-air passage 30. As indicated by airflow AF2, the air after cooling battery 10 and the air after cooling inverter 20 are exhausted together through cooling-air passage 30. Communicating portion 32 is formed downstream of battery 10, thereby allowing exhaust heat of inverter 20 to be prevented from flowing to battery 10 and lowering the cooling efficiency for battery 10. Moreover, maximum cooling of battery 10 can be achieved by supplying air using fan 40, thus allowing battery 10 to be cooled more efficiently, without affecting the cooling performance for battery 10.

Communicating portion 32 is formed to provide communication between cooling-air passage 30 and a portion near wall portion 52 of hollow space 50. Therefore, airflow AF4 created due to a pressure difference between cooling-air passage 30 and hollow space 50 flows along wall portion 52. Since inverter 20 is disposed near wall portion 52 and radiator fins 22 are disposed to face wall portion 52, airflow AF4 is warmed by heat exchange with radiator fins 22. Because airflow AF4 passes along wall portion 52 of hollow space 50, the air heated by inverter 20 flows toward communicating portion 32 without diffusing, thus achieving improvement in cooling performance. The direction of the flow of air along wall portion 52 is set by utilizing a wall surface of the existing hollow space 50 as a duct, thus eliminating the need to provide an additional duct for rectification, allowing inverter 20 to be efficiently cooled.

Because communicating portion 32 that provides communication between cooling-air passage 30 and hollow space 50 is formed, a flow of air from hollow space 50 toward cooling-air passage 30 is created utilizing a pressure difference between cooling-air passage 30 and hollow space 50, to promote the convection of the air heated by inverter 20, thereby allowing the cooling capability for inverter 20 to be enhanced. Cooling-air passage 30 and hollow space 50 may be disposed as desired as long as the interior spaces thereof communicate with each other via communicating portion 32. Preferably, however, cooling-air passage 30 and hollow space 50 are disposed adjacent to each other, with inverter 20 being disposed in a position as close to communicating portion 32 as possible, so as to enhance the cooling capability for inverter 20.

Further, cooling-air passage 30 is desirably disposed above hollow space 50. This allows the upward flow of the air warmed by the radiation of inverter 20 to be directed to the direction of the air toward communicating portion 32. Consequently, the air can be convected even more efficiently, allowing the cooling efficiency for inverter 20 to be further improved.

Fig. 4 is a schematic perspective view showing an example of radiator fins 22 provided on inverter 20. Radiator fins 22 shown in Fig. 4 are pin fins 22A formed by aligning multiple pin-shaped fins in two directions, i.e., vertically and horizontally. Gaps 24 are formed between pin fins 22A along a direction of the flow of airflow AF4 (the vertical direction in the figure). Air heated by radiation from pin fins 22A can flow through gaps 24 toward communicating portion 32. Pin fins 22A are disposed with gaps 24 being formed therebetween, so as not to block the flow of air that flows along wall portion 52 to communicating portion 32. Therefore, the convection of the air after heat radiation from pin fins 22A can be promoted, allowing the air-cooling efficiency for inverter 20 to be even further enhanced.

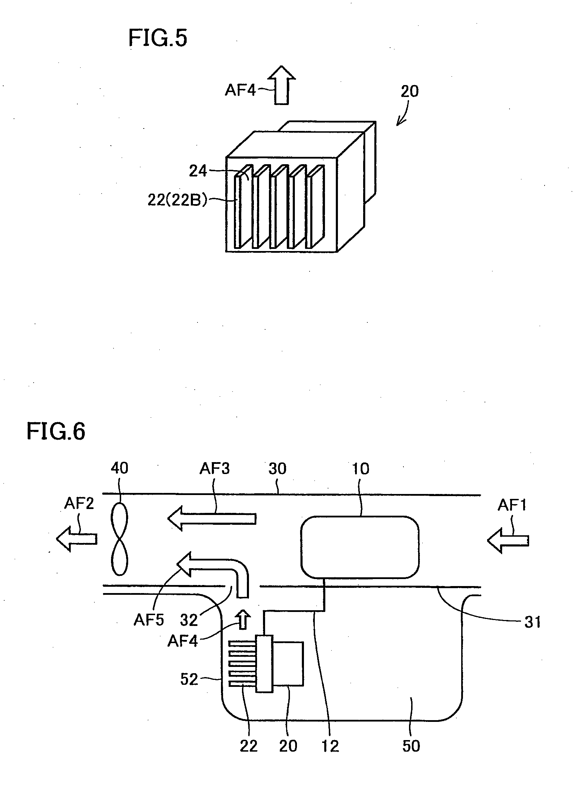

Fig. 5 is a schematic perspective view showing another example of radiator fins 22 provided on inverter 20. Radiator fins 22 shown in Fig. 5 are plate fins 22B formed by aligning plate-shaped fins in parallel. As shown in Fig. 2, with inverter 20 being disposed in hollow space 50, plate fins 22B are aligned perpendicularly to wall portion 31 of cooling-air passage 30. As with pin fins 22A shown in Fig. 4, gaps 24 are formed between plate fins 22B along the direction of the flow of airflow AF4 (the vertical direction in the figure). Air heated by radiation from plate fins 22B can flow through gaps 24 toward communicating portion 32. Plate fins 22B are disposed with gaps 24 being formed therebetween, so as not to block the flow of air that flows along wall portion 52 to communicating portion 32. Therefore, the convection of the air after radiation from plate fins 22B can be promoted, allowing the air-cooling efficiency for inverter 20 to be even further enhanced.

As shown in Figs. 4 and 5, gaps 24 are formed between radiator fins 22, which increase the radiation area of inverter 20 to improve the cooling efficiency, in a direction parallel to the flow of air toward communicating portion 32. That is, radiator fins 22 are formed so that gaps 24 extend in a direction perpendicular to wall portion 31 of cooling-air passage 30 in which communicating portion 32 is formed. This allows air heated by radiation from radiator fins 22 to efficiently flow via gaps 24 into communicating portion 32, allowing low-temperature air in hollow space 50 to be guided around radiator fins 22. Therefore, the cooling performance for inverter 20 using convection can be further enhanced.

### (Second Embodiment)

Fig. 6 is a schematic diagram showing the configuration of a cooling apparatus of a second embodiment when viewed laterally. The cooling apparatus of the second embodiment has a configuration substantially the same as that of the cooling apparatus of the first embodiment shown in Fig. 3. However, the cooling apparatus of the second embodiment differs from that of the first embodiment in terms of where fan 40 is disposed in cooling-air passage 30.

Specifically, in the first embodiment, battery 10 is disposed along the pathway from fan 40 to communicating portion 32 to block the flow of air, thereby causing a pressure loss. Consequently, the flow velocity of airflow AF3 in communicating portion 32 is lower than that right downstream of fan 40. In comparison, in the configuration of the second embodiment shown in Fig. 6, fan 40 is disposed downstream of communicating portion 32 in cooling-air passage 30. In this case, no devices and the like that cause a pressure loss are disposed in an interior space of cooling-air passage 30 that extends from communicating portion 32 to fan 40. Therefore, the flow velocity of airflow AF3 in communicating portion 32 can be increased as compared to that in the first embodiment.

When the flow velocity of airflow AF3 increases, the pressure in communicating portion 32 on the cooling-air passage 30 side decreases in accordance with Bernoulli's theorem. Additionally, considering that the pressure of the air ventilating in cooling-air passage 30 is increased by fan 40, the pressure of the air upstream of fan 40 is relatively low. Therefore, the internal pressure of cooling-air passage 30 in communicating portion 32 is further reduced. On the other hand, the internal pressure of hollow space 50 is the atmospheric pressure as in the first embodiment. Consequently, the pressure difference between the inside of cooling-air passage 30 and the inside of hollow space 50 is increased.

This increased pressure difference allows the flow velocity of airflows AF4, AF5 flowing into cooling-air passage 30 from hollow space 50 to increase, so as to increase the amount of intake air from hollow space 50 to cooling-air passage 30. Thus, the convection of air by radiator fins 22 can be further promoted. Therefore, the cooling capability for inverter 20 using airflow AF4 can be increased, so as to enhance the cooling capability for inverter 20.

Of the two heat-generating devices cooled by the cooling apparatus, where battery 10 disposed in cooling-air passage 30 is desirably cooled more, the configuration of the first embodiment, by which maximum cooling capability for battery 10 is achieved by fan 40, is preferred. On the other hand, where inverter 20 disposed in hollow space 50 is desirably cooled more, the configuration of the second embodiment, in which the pressure difference in communicating portion 32 is increased to improve the cooling capability for inverter 20, may be more preferred. That is, the disposition of fan 40 can be optimally determined based on the disposition of the heat-generating device that needs to be cooled more, of the heat-generating device disposed in cooling-air passage 30 and the heat-generating device disposed in hollow space 50.

The foregoing description has been made of an example in which the plurality of heat-generating devices cooled by the cooling apparatus are battery 10 and inverter 20 mounted on vehicle 100. The heat-generating devices are not limited to these devices, and may, for example, be DC-DC converters for auxiliary machinery, or other heat-generating devices mounted on vehicle 100.

Moreover, although an example has been described in which vehicle 100 incorporating the heat-generating devices is a hybrid car on which an engine and motors are mounted as driving power sources for propelling the vehicle, vehicle 100 may also be a car that generates a vehicle driving force using electric energy, such as an electric car or a fuel cell car.

### REFERENCE SIGNS LIST

10: battery, 12: cable, 20: inverter, 22: radiator fin, 22A: pin fin, 22B: plate fin, 24: gap, 30: cooling-air passage, 31: wall portion, 32: communicating portion, 40: fan, 50: hollow space, 52: wall portion, 100: vehicle, AF1-AF5: airflow

## Claims

1. A cooling apparatus for cooling a plurality of heat-generating devices (10, 20) mounted on a vehicle (100), said vehicle (100) having a hollow space (50) comprising:
a cooling-air passage (30) disposed adjacent to said hollow space (50);
a first heat-generating device (10) disposed in said cooling-air passage (30);
a second heat-generating device (20) disposed in said hollow space (50); and
a fan (40) for supplying air to said cooling-air passage (30),
a communicating portion (32) providing communication between said cooling-air passage (30) and said hollow space (50) being formed in a wall portion (31) of said cooling-air passage (30) facing said hollow space (50), **characterized in that** the hollow space (50) can accommodate a spare tire.

2. The cooling apparatus according to claim 1, wherein
said second heat-generating device (20) is disposed in proximity to a wall portion (52) of said hollow space (50).

3. The cooling apparatus according to claim 1 or 2, wherein
said second heat-generating device (20) is disposed to face said communicating portion (32).

4. The cooling apparatus according to any of claims 1 to 3, wherein
said fan (40) is disposed upstream of said first heat-generating device (10) in said cooling-air passage (30).

5. The cooling apparatus according to any of claims 1 to 3, wherein
said fan (40) is disposed downstream of said communicating portion (32) in said cooling-air passage (30).

6. The cooling apparatus according to any of claims 1 to 5, wherein
said second heat-generating device (20) has radiator fins (22).

7. The cooling apparatus according to claim 6, wherein
said radiator fins (22) are pin fins (22A), or plate fins (22B) aligned perpendicularly to said wall portion (31).

8. The cooling apparatus according to any of claims 1 to 7, wherein
each of said heat-generating devices (10, 20) is any of a battery, an inverter, and a DC-DC converter.

## Patentansprüche

1. Kühlgerät zum Kühlen von mehreren wärmeerzeugenden Vorrichtungen (10, 20), die auf einem Fahrzeug (100) angebracht sind, wobei das Fahrzeug (100) einen Hohlraum (50) aufweist, umfassend:
einen Kühlluftdurchgang (30), der neben dem Hohlraum (50) angeordnet ist,
eine erste wärmeerzeugende Vorrichtung (10), die in dem Kühlluftdurchgang (30) angeordnet ist,
eine zweite wärmeerzeugende Vorrichtung (20), die in dem Hohlraum (50) angeordnet ist, und
einen Ventilator (40), der dem Kühlluftdurchgang (30) Luft zuführt,
einen Kommunikationsabschnitt (32), der zwischen dem Kühlluftdurchgang (30) und dem Hohlraum (50), der in einem Wandabschnitt (31) des Kühlluftdurchgangs (30) gegenüber dem Hohlraum (50) gebildet ist, eine Kommunikation bereitstellt, **dadurch gekennzeichnet, dass** der Hohlraum (50) ein Ersatzrad aufnehmen kann.

2. Kühlgerät nach Anspruch 1, wobei
die zweite wärmeerzeugende Vorrichtung (20) nahe eines Wandabschnittes (52) des Hohlraumes (50) angeordnet ist.

3. Kühlgerät nach Anspruch 1 oder 2, wobei
die zweite wärmeerzeugende Vorrichtung (20) derart angeordnet ist, dass sie dem Kommunikationsabschnitt (32) gegenüberliegt.

4. Kühlgerät nach einem der Ansprüche 1 bis 3, wobei
der Ventilator (40) stromaufwärts der ersten wärmeerzeugenden Vorrichtung (10) in dem Kühlluftdurchgang (30) angeordnet ist.

5. Kühlgerät nach einem der Ansprüche 1 bis 3,
wobei der Ventilator (40) stromabwärts des Kommunikationsabschnittes (32) in dem Kühlluftdurchgang (30) angeordnet ist.

6. Kühlgerät nach einem der Ansprüche 1 bis 5, wobei
die zweite wärmeerzeugende Vorrichtung (20) Heizkörperlamellen (22) aufweist.

7. Kühlgerät nach Anspruch 6, wobei
die Heizkörperlamellen (22) Stiftlamellen (22A) oder Plattenlamellen (22B) sind, die senkrecht zum Wandabschnitt (31) ausgerichtet sind.

8. Kühlgerät nach einem der Ansprüche 1 bis 7, wobei
jede der wärmeerzeugenden Vorrichtungen (10, 20) eines von einer Batterie, einem Wechselrichter und einem DC-DC-Wandler ist.

## Revendications

1. Équipement de refroidissement destiné à refroidir une pluralité de dispositifs générateurs de chaleur (10, 20) montés sur un véhicule (100), ledit véhicule (100) comportant un espace creux (50), comprenant :
un conduit d'air de refroidissement (30) disposé adjacent audit espace creux (50) ;
un premier dispositif générateur de chaleur (10) disposé dans ledit conduit d'air de refroidissement (30) ;
un second dispositif générateur de chaleur (20) disposé dans ledit espace creux (50) ; et
un ventilateur (40) destiné à fournir de l'air audit conduit d'air de refroidissement (30),
une partie communicante (32) réalisant une communication entre ledit conduit d'air de refroidissement (30) et ledit espace creux (50) étant formée dans une partie de paroi (31) dudit conduit d'air de refroidissement (30) faisant face audit espace creux (50),
**caractérisé en ce que** l'espace creux (50) peut loger une roue de secours.

2. Équipement de refroidissement selon la revendication 1, dans lequel ledit second dispositif générateur de chaleur (20) est disposé à proximité d'une partie de paroi (52) dudit espace creux (50).

3. Équipement de refroidissement selon la revendication 1 ou 2, dans lequel ledit second dispositif générateur de chaleur (20) est disposé pour faire face à ladite partie communicante (32).

4. Équipement de refroidissement selon l'une quelconque des revendications 1 à 3, dans lequel ledit ventilateur (40) est disposé en amont dudit premier dispositif générateur de chaleur (10) dans ledit conduit d'air de refroidissement (30).

5. Équipement de refroidissement selon l'une quelconque des revendications 1 à 3, dans lequel ledit ventilateur (40) est disposé en aval de ladite partie communicante (32) dans ledit conduit d'air de refroidissement (30).

6. Équipement de refroidissement selon l'une quelconque des revendications 1 à 5, dans lequel ledit second dispositif générateur de chaleur (20) possède des ailettes de radiateur (22).

7. Équipement de refroidissement selon la revendication 6, dans lequel lesdites ailettes de radiateur (22) sont des ailettes-aiguilles (22A), ou des ailettes plates (22B) alignées perpendiculairement à ladite partie de paroi (31).

8. Équipement de refroidissement selon l'une quelconque des revendications 1 à 7, dans lequel chacun desdits dispositifs générateurs de chaleur (10, 20) est l'un quelconque d'une batterie, d'un inverseur et d'un convertisseur de courant continu en courant continu.
